(19) Europäisches Patentamt

European Patent Office

Office européen des brevets

(11) Numéro de publication: **0 272 965 B1**

(12) **FASCICULE DE BREVET EUROPEEN**

(45) Date de publication de fascicule du brevet: **27.01.93**

(21) Numéro de dépôt: **87402712.1**

(22) Date de dépôt: **01.12.87**

(51) Int. Cl.⁵: **G01R 23/06**, G01R 23/09, G01P 3/48

(54) **Convertisseur fréquence-tension.**

(30) Priorité: **02.12.86 FR 8616807**

(43) Date de publication de la demande:
**29.06.88 Bulletin 88/26**

(45) Mention de la délivrance du brevet:
**27.01.93 Bulletin 93/04**

(84) Etats contractants désignés:
**CH DE GB IT LI NL**

(56) Documents cités:
**CH-A- 586 396**
**DE-A- 2 031 707**
**DE-A- 2 655 550**
**US-A- 3 839 673**

(73) Titulaire: **SGS-THOMSON MICROELECTRO-
NICS S.A.
101 Boulevard Murat
F-75016 Paris(FR)**

(72) Inventeur: **Moreau, Jean-Michel
THOMSON-CSF SCPI 19, avenue de Messine
F-75008 Paris(FR)**

(74) Mandataire: **de Beaumont, Michel et al
1bis, rue Champollion
F-38000 Grenoble(FR)**

## Description

La présente invention concerne les convertisseurs fréquence-tension qui permettent, de manière générale, de convertir des signaux récurrents en une grandeur électrique proportionnelle à leur fréquence de récurrence, la grandeur électrique étant le plus souvent un niveau de tension.

Lorsque l'on a un phénomène récurrent et que l'on veut mesurer la fréquence de récurrence du phénomène il est usuel d'utiliser un convertisseur fréquence-tension comportant un multivibrateur monostable suivi d'un filtre de type R.C. Chaque occurrence du phénomène déclenche le multivibrateur qui fournit une impulsion calibrée. Le signal obtenu est appliqué à l'entrée du filtre qui délivre une tension proportionnelle au nombre d'impulsions d'entrée par unité de temps, c'est-à-dire, proportionnelle à la fréquence que l'on souhaite mesurer. L'inconvénient d'un tel dispositif est que l'indication de la fréquence ne peut être obtenue qu'au bout d'un certain nombre d'impulsions ce qui ne permet pas de connaître cette fréquence instantanément.

Ceci n'a pas en fait été un réel inconvénient tant que l'on ne cherchait à réaliser que des convertisseurs fréquence-tension qui donnent une indication non instantanée de la fréquence de l'évènement récurrent et c'était le cas dans le domaine de l'électronique automobile, où l'on ne cherchait à faire que des appareils de mesure de la vitesse du moteur pour la faire apparaître sur le compte-tour du tableau de bord de l'automobile. Il n'était donc pas nécessaire que la mesure soit instantanée.

L'utilisation de tels convertisseurs a changé avec l'apparition des systèmes d'allumage électronique. En effet, ces systèmes utilisent comme l'une de leurs grandeurs d'entrée la valeur instantanée de la vitesse du moteur. Il est important d'élaborer un signal électrique qui permette de repérer certains angles de rotation du moteur. La manière classique d'y parvenir est de charger ou décharger un condensateur à courant constant, à partir d'une tension initialisée à chaque période. Alors pour que la tension instantanée représente l'angle de rotation du moteur, le courant de décharge doit être proportionnel à la vitesse, mais en période d'accélération ou de décélération du moteur, la mesure de la vitesse est erronée, l'information d'angle est faussée et tout le cycle d'allumage est compromis.

Un tel système ne peut pas donner de bons résultats car il ne dispose pas à chaque période de la valeur vraie de la fréquence instantanée.

Le document DE-A-2 655 550 décrit un convertisseur fréquence-tension permettant d'obtenir une tension dépendant de la fréquence instantanée. Toutefois, la tension obtenue n'est pas proportionnelle à la fréquence instantanée, ce qui est gênant pour connaître la valeur de la fréquence instantanée.

La présente invention permet de remédier à ces inconvénients en proposant un convertisseur fréquence-tension qui permet de connaître la valeur instantanée de la fréquence de récurrence d'un phénomène c'est-à-dire la valeur de la fréquence pour une récurrence par rapport à la récurrence précédente, c'est-à-dire encore l'inverse de la dernière période.

La présente invention a donc pour objet un convertisseur fréquence-tension comprenant des premiers moyens de stockage d'énergie susceptibles d'être couplés, soit à une source de tension, soit à un générateur de courant de décharge ; des deuxièmes moyens de stockage d'énergie susceptibles d'être couplés aux premiers moyens de stockage ; et un séquenceur desdits couplages des premier et deuxième moyens de stockage, recevant un signal récurrent dont la période de récurrence T est susceptible de varier et provoquant au début de chaque période T, pendant une durée T0, la charge des premiers moyens de stockage jusqu'à une valeur V0 ; caractérisé en ce que le générateur de courant est un générateur d'un courant de décharge Jd proportionnel au carré de la tension résiduelle instantanée des premiers moyens de stockage, et en ce que le séquenceur provoque la décharge des premiers moyens de stockage par ledit courant de décharge Jd dès la fin de la durée T0 pendant le restant T-T0 de la période et la recopie de la charge résiduelle des premiers moyens de stockage dans les deuxièmes moyens de stockage au début de la période suivante.

D'autres particularités et avantages de l'invention apparaîtront mieux à la lecture de la description détaillée qui suit et se réfère aux dessins annexés, donnés à titre d'exemples non limitatifs et dans lesquels :

- la figure 1 représente le schéma de principe d'un convertisseur selon l'invention,
- La figure 2 représente un chronogramme relatif à la figure 1,
- la figure 3 représente le schéma d'une réalisation particulière d'un convertisseur selon l'invention.

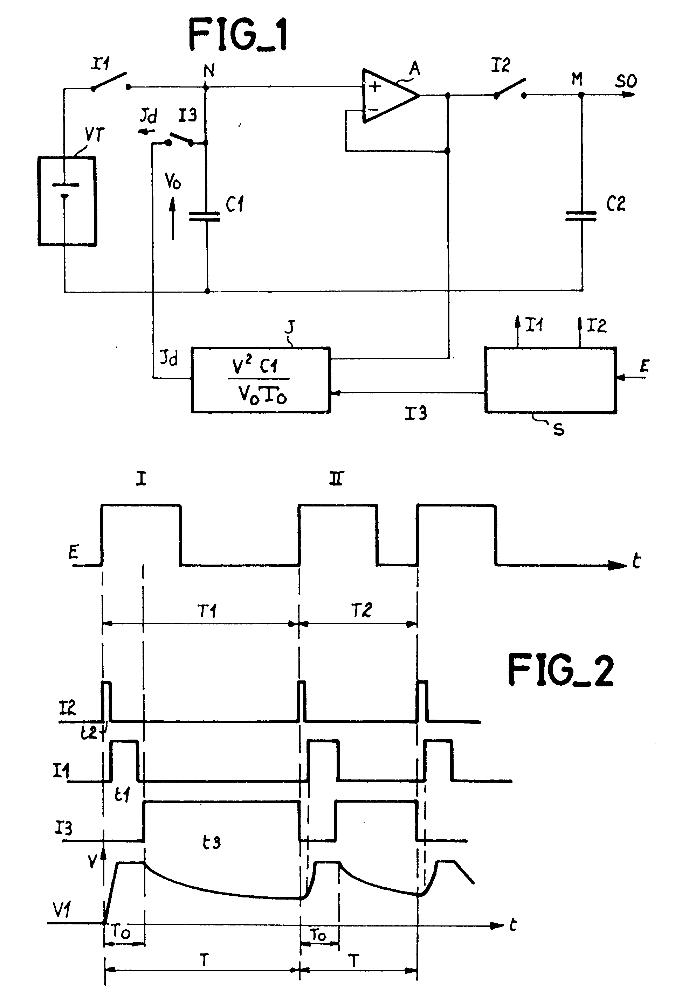

Sur la figure 1, on a représenté une source de tension VT qui permet de charger un premier condensateur C1 par l'intermédiaire d'un interrupteur I1 d'une valeur Vo. La décharge du condensateur C1 est faite à partir d'un source de courant J et d'un interrupteur I3 placé entre cette source J et une borne N du condensateur C1. Un amplificateur opérationnel A, monté en suiveur de tension ayant une sortie à faible impédance, a son entrée positive reliée à la borne N du condensateur C1 et sa sortie reliée à son entrée négative. Il permet de connaître à chaque instant la valeur de la tension aux bornes du condensateur C1.

Un deuxième condensateur C2 est relié de manière à pouvoir emmagasiner une charge sous une tension égale à celle du premier condensateur. Un interrupteur I2 connecté entre la sortie de l'amplificateur A et une borne M du condensateur C2, permet ou non, le transfert de l'énergie. L'ouverture et la fermeture des interrupteurs sont commandées par un séquenceur S qui crée les signaux de commande à partir du signal récurrent d'entrée E.

Le séquenceur S est déclenché par ce signal d'entrée E et délivre un signal de commande de fermeture de l'interrupteur I2 pour provoquer le stockage de la charge proportionnelle à la tension résiduelle V, du condensateur C1 dans le condensateur C2. Le séquencer S commande ensuite l'ouverture de l'interrupteur I2, puis la fermeture de l'interrupteur I1 pendant une durée To pour charger le condensateur C1 de la valeur Vo. La durée du transfert de la tension résiduelle V est négligeable par rapport à la durée du stockage de la tension Vo. A la fin de la durée To et pendant le reste de la période en cours c'est-à-dire pendant une durée T-T0, on applique un courant de décharge Jd proportionnel au carré de la tension instantanée du condensateur C1 par commodité, mesurée à la sortie de l'amplificateur. La fin de la période T déclenche le chargement de la valeur résiduelle C1V du condensateur C1 dans le condensateur C2.

On choisit le courant Jd de sorte que la tension mémorisée par le condensateur C2 soit proportionnelle à l'inverse de la période T,

$$Jd = \frac{V^2 C1}{VoTo},$$

(C1 représentant la valeur de la capacité du condensateur référencé C1.)

La source de courant peut être réalisée, par exemple, au moyen de multiplieurs de type Gilbert que l'on trouve couramment fabriqués sous forme de circuits intégrés monolithiques.

En effet, un tel multiplieur est apte à fournir une tension (ou un courant) proportionnelle au carré d'une tension d'entrée lorsque l'on applique cette tension sur ses deux entrées.

Sur la figure 2, on a représenté un chronogramme des signaux de commande des interrupteurs I1, I2, I3, du signal incident E et de la tension aux bornes du condensateur C1.

Le signal E est un signal présentant une périodicité, ce signal périodique est obtenu par exemple à la sortie d'un capteur de vitesse lorsqu'il s'agit de connaître la vitesse d'un moteur automobile pour effectuer de l'avance à l'allumage.

Le signal E a une période de récurrence qui est susceptible de varier lorsque le phénomène physique récurrent d'origine a une fréquence qui varie. C'est le cas, suivant l'exemple précédent, lorsqu'on effectue la mesure de vitesse d'un moteur et que le moteur subit un accélération ou une décélération.

Pour illustrer ce phénomène, on a représenté une première phase I avec une période d'une durée T1 et une deuxième phase II avec une période de durée T2.

A l'arrivée d'une impulsion du signal E, l'interrupteur I2 est fermé pendant une durée t2, il est ouvert pendant le reste de la période c'est-à-dire pendant la durée T-t2. La fermeture de l'interrupteur I2 permet de mémoriser la tension V du condensateur C1 dans le condensateur C2.

L'interrupteur I1 est fermé pour charger le condensateur C1 à une valeur Vo pendant une durée t1 qui peut être égale à To de manière à ce que le condensateur soit chargé à V1 à l'instant To. Les interrupteurs I2 et I3 sont ouverts. Pendant le reste de la période T-To, l'interrupteur I3 est fermé, le condensateur C1 se décharge par application du courant de décharge Jd.

Pendant la période suivante on procède de la même manière, le condensateur C2 est chargé par la tension V résiduelle du condensateur C1, l'interrupteur I2 étant fermé pour cela. Le condensateur C1 est chargé de façon à avoir la tension Vo à l'instant To. Ce condensateur est ensuite déchargé par le courant Jd. La période de cette deuxième phase étant plus courte que celle de la première phase, le condensateur C1 se décharge par conséquent d'un quantité moindre, la tension à ses bornes, qui est chargée aux bornes du condensateur C2 à la fin de la période en cours, traduit instantanément cette variation.

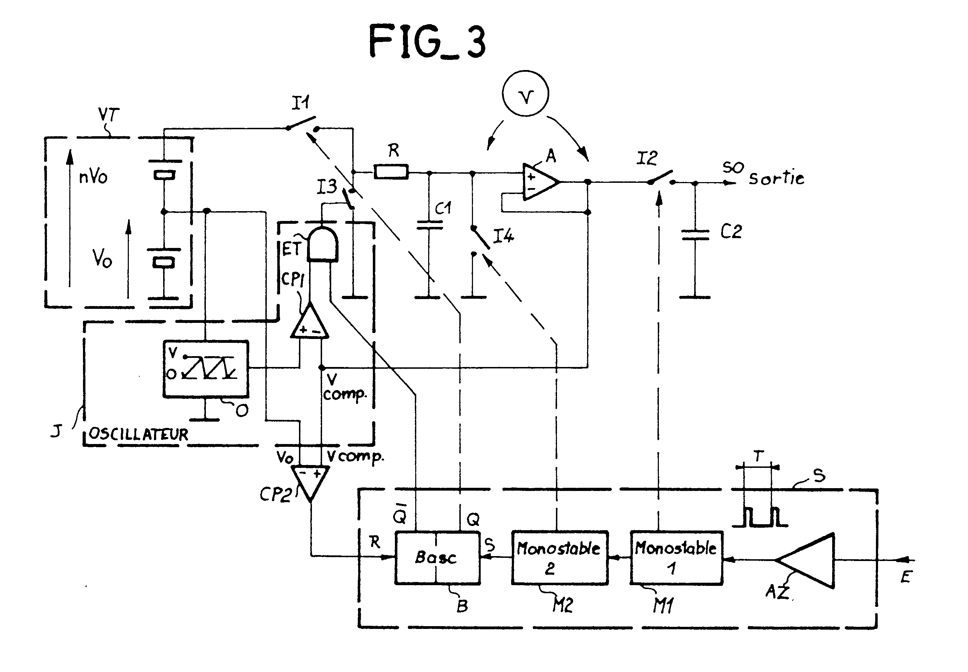

Sur la figure 3, on a représenté une réalisation particulière du convertisseur selon l'invention.

Pour obtenir la base de temps To, on utilise une source de tension VT correspondant à n.Vo, n étant en réel. Une résistance R est connectée entre l'interrupteur I1 et le condensateur C1. Lorsque l'interrupteur I1 est fermé, les interrupteurs I3 et I4 étant ouverts, la tension nVo est appliquée à la résistance R. L'interrupteur I4 est connecté en parallèle sur le condensateur C1. Le condensateur C1 se charge avec une constante de temps RC1 et selon la loi suivante :

$$V = nVo \left(1 - e^{\frac{-t}{RC}}\right).$$

Pour obtenir que t = To lorsque V = Vo on prédétermine n de sorte que :

$$To = RC1 \log \frac{n}{n-1}$$

Le séquenceur S comporte un amplificateur adaptateur AZ recevant le signal d'entrée E et transformant ce signal en des impulsions. Un monostable M1 est connecté en série avec l'amplificateur AZ et permet de commander l'interrupteur I2. Un monostable M2 est déclenché par le monostable M1 et permet de commander l'interrupteur I4. Une bascule B de type RS est commandé par le monostable M2 et permet de commander les interrupteurs I1 et I3.

Le circuit J du courant de décharge comporte un oscillateur en dent de scie O, deux comparateurs CP1, CP2 et une porte ET. Ce circuit permet selon cette réalisation particulière d'avoir une décharge du condensateur C1, hyperbolique car, bien entendu, le courant de décharge est selon l'invention proportionnel à $V^2$. Ce courant est obtenu grâce au mode de réalisation préféré de l'invention décrit ci-après.

L'oscillateur est connecté aux bornes d'une source de tension Vo. La tension à sa sortie est en dent de scie et varie entre les valeurs O volt et Vo. Cette tension est appliquée à une entrée du comparateur CP1, l'autre entrée du comparateur étant reliée à la sortie de l'amplificateur A pour recevoir le niveau de tension V. La sortie du comparateur CP1 est reliée à une entrée de la porte ET, l'autre entrée de la porte est reliée à la sortie inversée de la bascule B. Si on adopte comme convention qu'un état haut (niveau logique 1) commande l'état fermé d'un interrupteur, la sortie non inversée de la bascule permet de commander l'interrupteur I1. Le comparateur CP2 reçoit par une entrée la tension Vo et à l'autre entrée la tension V de sortie de l'amplificateur. La sortie du comparateur CP2 est reliée à l'entrée R de la bascule.

Le monostable M1 déclenché par le signal d'entrée E, permet de fermer I2, pour stocker la valeur instantanée de la charge C1V du condensateur C1 dans le condensateur C2. Les interrupteurs I1 et I4 sont ouverts. La position de l'interrupteur I3 est indifférente.

A la suite de cette première étape, le monostable M2 déclenché par la fin de l'étape 1 commande la fermeture de l'interrupteur I4 pour décharger le condensateur C1 à O volt, les interrupteurs I1 et I2 sont ouverts, la position de I3 est indifférente.

Dans une troisième étape, la bascule B déclenchée par la fin de la deuxième étape maintient les interrupteurs I1 fermé et I3 ouvert. Les interrupteurs I2 et I4 sont ouverts. Le condensateur C1 se charge.

Selon une quatrième étape, lorsque la tension aux bornes du condensateur est égale à Vo, cette information étant donnée par le comparateur CP2, la sortie Q de la bascule provoque l'ouverture de I1. Les interrupteurs I2 et I4 restent ouverts. L'interrupteur I3 s'ouvre et se ferme alternativement, et sa fermeture ne dure chaque fois que pendant tout le temps que la tension V est inférieure à la tension de l'oscillateur O ; cette information est donnée par le comparateur CP1. L'oscillateur O est choisi de sorte que sa période soit beaucoup plus courte que la plus courte période à mesurer.

Le courant de décharge dans R, (soit $\frac{V}{R}$ ) ne passe donc que pendant le fraction

$$\frac{V}{Vo}$$

du temps.

On obtient donc un courant de valeur "moyenne" Jd tel que

$$Jd = \frac{V^2}{RVo} .$$

Il s'agit de la moyenne prise sur un temps faible devant la période du signal et fort devant la période de l'oscillateur.

Cette quatrième étape se poursuit jusqu'à ce qu'une nouvelle impulsion obtenue à partir du signal d'entrée déclenche une nouvelle étape 1. La tension V résiduelle est donc directement proportionnelle à la valeur 1/T (c'est-à-dire à la fréquence de récurrence). En effet, au bout d'un temps:

$$t = T, V = \frac{VoTo}{T} .$$

On connaît par conséquent la fréquence réelle, c'est-à-dire l'inverse de la période aussitôt la période terminée, par mesure de la tension à la sortie SO.

Les interrupteurs I1, I2, I3, I4 peuvent être réalisés soit par des transistors bipolaires fonctionnant en mode saturé-bloqué, soit des transistors à effet de champ soit par tout autre moyen connu de l'homme de l'art.

Le convertisseur est réalisable sous forme de circuit intégré monolithique.

**Revendications**

1. Convertisseur fréquence-tension comprenant des premiers moyens de stockage d'énergie (C1) susceptibles d'être couplés, soit à une source de tension (VT), soit à un générateur de courant de décharge (J) ; des deuxièmes moyens de stockage d'énergie (C2) susceptibles d'être couplés aux premiers moyens de stockage (C1) ; et un séquenceur (S) desdits couplages des premiers (C1) et deuxièmes (C2) moyens de stockage, recevant un signal récurrent (E) dont la période de récurrence T est susceptible de varier, et provoquant au début de chaque période T, pendant une durée T0, la charge des premiers moyens de stockage (C1) jusqu'à une valeur V0 ; caractérisé en ce que le générateur de courant (J) est un générateur d'un courant de décharge (Jd) proportionnel au carré de la tension résiduelle instantanée (V) des premiers moyens de stockage (C1), et en ce que le séquenceur (S) provoque la décharge des premiers moyens de stockage (C1) par ledit courant de décharge (Jd) des la fin de la durée T0 pendant le restant T-T0 de la période et la recopie de la charge résiduelle des premiers moyens de stockage (C1) dans les deuxièmes moyens de stockage (C2) au début de la période suivante.

2. Convertisseur fréquence-tension selon la revendication 1 caractérisé en ce que les premiers moyens de stockage de l'énergie comportent un premier condensateur (C1) et en ce que les deuxièmes moyens de stockage comportent un deuxième (C2) condensateur, la charge du premier condensateur étant autorisée par un premier interrupteur (I1), la charge du deuxième condensateur (C2) étant autorisée par un deuxième interrupteur (I2) tous deux actionnés par des signaux de commande délivrés par le séquenceur (S).

3. Convertisseur selon la revendication 1 ou 2, caractérisé en ce qu'il comporte des moyens de mesure (A) de la tension instantanée V aux bornes du premier condensateur (C1), et en ce que ces moyens sont reliés au générateur de courant (J) pour établir le courant de décharge (Jd) proportionnel au carré de cette tension.

4. Convertisseur selon l'une quelconque des revendications 1 à 3, caractérisé en ce qu'un troisième interrupteur (I3) permet de décharger le premier condensateur (C1) de la tension V0 à V par application du courant de décharge (Jd).

5. Convertisseur selon la revendication 3 et la revendication 4, caractérisé en ce que le générateur de courant de décharge (Jd) est constitué d'un multiplisateur dont deux entrées sont reliées à la sortie des moyens de mesure (A) et dont la sortie délivre le courant Jd tel qu'il soit égal à :

$$\frac{V^2 C1}{V0 T0}.$$

6. Convertisseur selon la revendication 3 et la revendication 4, caractérisé en ce que, le générateur de courant de décharge (Jd) comporte un oscillateur (O) dont la tension de sortie varie entre O et Vo ; un premier comparateur (CP1) recevant la tension de sortie de l'oscillateur (O) à une entrée et la tension de sortie des moyens de mesure (A) à une autre entrée ; une porte ET recevant le signal de sortie du comparateur (CP1) à une entrée et un signal de commande du séquenceur (S), la sortie de la porte ET étant apte à ouvrir ou fermer le troisième interrupteur (I3) ; et en ce que un quatrième interrupteur (I4) est connecté en parallèle sur le condensateur (C1).

7. Convertisseur selon l'une quelconque des revendications 1 à 6 caractérisé en ce que la source de tension (VT) a pour valeur nVo et en ce que les premiers moyens de stockage comportent une résistance (R) connectée entre le premier interrrupteur (I1) et le premier condensateur (C1), la tension nVo étant appliquée sur la résistance (R), ce condensateur se chargeant pendant une durée T0 fonction de la constante de temps RC1 ; ces moyens de stockage comportant également un deuxième comparateur (CP2) dont une entrée reçoit la tension de mesure (A), la sortie de ce comparateur permet au séquenceur (S) de commander la fermeture ou l'ouverture du premier interrupteur (I1).

8. Convertisseur selon l'une quelconque des revendications 1 à 7, caractérisé en ce que le séquenceur (S) comporte un premier monostable (M1) recevant le signal d'entrée et activant le deuxième interrupteur (I2), un deuxième monostable (M2) déclenché par le premier et activant le quatrième interrupteur (I4).

9. Convertisseur selon les revendications 6, 7 et 8, caractérisé en ce que le séquenceur (S) comporte une bascule (B) de type RS déclenchée par le deuxième monostable (M2) et par la sortie du deuxième comparateur (CP2), un état de sortie activant le premier interrupteur (I1), l'autre état de sortie activant la deuxième entrée de la porte ET.

**10.** Convertisseur selon l'une quelconque des revendications 3 à 9, caractérisé en ce que les moyens de mesures sont constitués par un amplificateur opérationnel (A) monté en suiveur de tension.

**11.** Convertisseur selon l'une quelconque des revendications 1 à 10, caractérisé en ce que les interrupteurs sont des transistors bipolaires ou des transistors à effet de champ.

**Claims**

**1.** A frequency-voltage converter comprising first energy storage means (C1) liable to be connected either to a voltage source (VT) or to a discharge current generator (J); second energy storage means (C2) liable to be connected to said first storage means (C1); a sequencer (S) for the connections of the first (C1) and second (C2) storage means, receiving a recurrent signal (E) whose recurrence period T can be varied and a stablishing at the beginning of each period T, for a time To, the charging of the first storage means (C1) up to a value Vo; characterized in that the current generator (J) generates a discharge current (Jd) proportional to the square of the instantaneous residual voltage (V) of the first storage means (C1) and in that the sequencer (S) establishes the discharge of the first storage means (C1) by said discharge current (Jd) at the end of time To during the remaining time T-To of the period and the copy of the residual charge of the first storage means (C1) into the second storage means (C2) at the beginning of the next period.

**2.** The frequency-voltage converter of claim 1 characterized in that first energy storage means include a first capacitor (C1) and the second storage means include a second capacitor (C2), charging of the first capacitor being made possible by a first switch (I1), charging of the second capacitor (C2) being made possible by a second switch (I2), both actuated by control signals delivered by the sequencer (S).

**3.** The converter as claimed in claim 1 or 2, characterized in that it includes means (A) for measuring the instantaneous voltage V across the first capacitor (C1) and that these means are connected to the current generator for providing the discharge current (Jd) proportional to the square of this voltage.

**4.** The converter as claimed in any of claims 1 to 3, characterized in that it includes a third switch (I3) for discharging the first capacitor (C1) from the voltage Vo to V by application of the discharge current (Jd).

**5.** The converter as claimed in claims 3 and 4, characterized in that said discharge current generator (Jd) comprises a multiplier whose two inputs are connected to the output of the measurement means (A) and whose output delivers the current Jd such that it is equal to $V^2 C1/VoTo$.

**6.** The converter as claimed in claims 3 and 4, characterized in that said discharge current generator (Jd) includes an oscillator (O) whose output voltage varies between O and Vo; a first comparator (CP1) receiving the output voltage from the oscillator (O) at one input and the output voltage of the measuring means (A) at the other input; and AND gate receiving the output signal from the comparator (CP1) at one input and a signal for controlling the sequencer (S), the output of the AND gate being adapted for opening or closing the third switch (I3); and a fourth switch (I4) is connected in parallel across said capacitor (C1).

**7.** The converter as claimed in any of claims 1 to 6, wherein said voltage source (VT) has for value nVo and said first storage means include a resistor (R) connected between the first switch (I1) and the first capacitor (C1), the voltage nVo being applied to the resistor (R), this capacitor being charged for a time To depending on the time constant RC1; these storage means also including a second comparator (CP2) one input of which receives the voltage Vo and another input of which receives an output voltage from the measuring means (A), the output of this comparator making it possible for the sequencer (S) to control the closure or opening of the first switch (I1).

**8.** The converter as claimed in any of claims 1 to 7 characterized in that said sequencer includes a first monostable (M1) receiving the input signal and activating the second switch (I2), a second monostable (M2) tripped by the first one and activating the fourth switch (I4).

**9.** The converter as claimed in claims 6, 7 and 8, characterized in that said sequencer (S) includes an RS type flip flop (B) tripped by the second monostable (M2) and by the output of the second comparator (CP2), one output state activating the first switch (I1), the other output state activating the second input of the AND gate.

**10.** The converter as claimed in any of claims 3 to 9, characterized in that said measuring means are formed by an operational amplifier (A) connected as a voltage follower.

**11.** The converter as claimed in any of claims 1 to 10 wherein the switches are bipolar transistors or field effect transistors.

**Patentansprüche**

**1.** Frequenz-Spannungs-Wandler mit einer ersten Energiespeicher-Vorrichtung (C1) für den Anschluß an entweder eine Spannungsquelle (VT) oder einen Entladestrom-Erzeuger (J), einer zweiten Energiespeichervorrichtung (C2) für den Anschluß an die erste Speichervorrichtung (C1) und mit einem Folgeschalter (S) zum Verbinden der ersten (C1) und der zweiten (C2) Speichervorrichtungen, der ein periodisches Signal (E) empfängt, dessen Rücklaufperiode T veränderbar ist, und der am Anfang jeder Periode T während einer Dauer T0 die Aufladung der ersten Speichervorrichtung (C2) bis zu einem Wert V0 einleitet, dadurch **gekennzeichnet**, daß der Stromerzeuger (J) einen Entladestrom (Jd) erzeugt, der proportional zum Quadrat der momentanen Restspannung (V) der ersten Speichervorrichtung (C1) ist, und daß der Folgeschalter (S) die Entladung der ersten Speichervorrichtung (C1) durch diesen Entladestrom (Jd) am Ende der Zeitspanne T0 während des Restes T-T0 der Periode und die Nachbildung der Restladung der ersten Speichervorrichtung (C1) in der zweiten Speichervorrichtung (C2) am Anfang der nachfolgenden Periode einleitet.

**2.** Frequenz-Spannungs-Wandler nach Anspruch 1, dadurch **gekennzeichnet**, daß die erste Energiespeicher-Vorrichtung einen ersten Kondensator (C1) aufweist und die zweite Energiespeicher-Vorrichtung einen zweiten Kondensator (C2) aufweist, das Laden des ersten Kondensators durch einen ersten Unterbrecher (I1) möglich ist und das Laden des zweiten Kondensators (C2) durch einen zweiten Unterbrecher (I2) möglich ist, wobei beide durch vom Folgeschalter (S) ausgegebene Signale betätigbar sind.

**3.** Wandler nach Anspruch 1 oder 2, **gekennzeichnet** durch eine Vorrichtung zum Messen (A) der momentanen Spannung V an den Anschlüssen des ersten Kondensators (C1), die mit dem Stromerzeuger (J) verbunden ist, um den dem Quadrat dieser Spannung proportionalen Entladestrom (Jd) aufzubauen.

**4.** Wandler nach einem der Ansprüche 1 bis 3, **gekennzeichnet** durch einen dritten Unterbrecher (I3) zum Entladen des Kondensators (C1) von der Spannung V0 auf V durch Anlegen des Entladestroms (Jd).

**5.** Wandler nach Anspruch 3 und 4, dadurch **gekennzeichnet**, daß der Entladestrom (Jd)-Erzeuger einen Multiplizierer aufweist, dessen zwei Eingänge mit dem Ausgang der Meßvorrichtung (A) verbunden sind und dessen Ausgang den Strom Jd liefert, der gleich:

$$\frac{V^2 \cdot C1}{V0 \cdot T0}$$

ist.

**6.** Wandler nach Anspruch 3 und 4, dadurch **gekennzeichnet**, daß der Entladestrom (Jd)-Erzeuger einen Oszillator (O) aufweist, dessen Ausgangsspannung zwischen 0 und V0 variiert, sowie einen ersten Vergleicher (CP1), der die Ausgangsspannung des Oszillators (O) an einem Eingang und die Ausgangsspannung der Meßvorrichtung (A) am anderen Eingang empfängt, und ein UND-Gatter aufweist, welches das Ausgangssignal des Vergleichers (CP1) an einem Eingang und ein Steuersignal des Folgeschalters (S) am anderen Eingang empfängt, wobei der Ausgang des UND-Gatters zum Öffnen oder Schließen eines dritten Unterbrechers (I3) geeignet ist, und daß parallel zum Kondenstor (C1) ein vierter Unterbrecher (I4) angeschlossen ist.

**7.** Wandler nach einem der Ansprüche 1 bis 6, dadurch **gekennzeichnet**, daß die Spannungsquelle (VT) den Wert nV0 hat und daß die erste Speichervorrichtung einen Widerstand (R) aufweist, der zwischen dem ersten Unterbrecher (I1) und dem ersten Kondensator (C1) angeschlossen ist, wobei die Spannung nV0 am Widerstand (R) anliegt und sich der Kondensator während einer Zeitdauer T0 auflädt, die eine Funktion der Zeitkonstante RC1 ist, und daß die Speichervorrichtung auch einen zweiten Vergleicher (CP2) aufweist, dessen einer Eingang die Spannung V0 und dessen anderer Eingang eine Ausgangsspannung der Meßvorrichtung (A) empfängt, wobei der Ausgang dieses Vergleichers dem Folgeschalter (S) ermöglicht, das Schließen oder Öffnen des ersten Unterbrechers (I1) zu steuern.

8. Wandler nach einem der Ansprüche 1 bis 7,dadurch **gekennzeichnet**, daß der Folgeschalter (S) eine erste monostabile Schaltung (M1), welche das Eingangssignal empfängt und den zweiten Unterbrecher (I2) aktiviert, und eine zweite monostabile Schaltung (M2) aufweist, die durch die erste auslösbar ist und den vierten Unterbrecher (I4) aktiviert.

9. Wandler nach den Ansprüchen 6, 7 und 8, dadurch **gekennzeichnet**, daß der Folgeschalter (S) eine RS-Kippschaltung (B) aufweist, die durch die zweite monostabile Schaltung (M2) und den Ausgang des zweiten Vergleichers (CP2) auslösbar ist, wobei ein Ausgangszustand den ersten Unterbrecher (I1) und der andere Ausgangszustand den zweiten Eingang des UND-Gatters aktiviert.

10. Wandler nach einem der Ansprüche 3 bis 9, dadurch **gekennzeichnet**, daß die Meßvorrichtung von einem als Spannungsfolger angeschlossenen Operationsverstärker (A) gebildet ist.

11. Wandler nach einem der Ansprüche 1 bis 10, dadurch **gekennzeichnet**, daß die Unterbrecher bipolare Transistoren oder Feldeffekt-Transistoren sind.

# FIG_1

$$\frac{V^2 C1}{V_0 T_0}$$

# FIG_2

# FIG_3

EP 0 272 965 B1